Europäisches Patentamt

European Patent Office

Office européen des brevets

(19)

(11) Veröffentlichungsnummer: **0 111 827 B2**

# NEUE EUROPÄISCHE PATENTSCHRIFT

(12)

(45) Veröffentlichungstag der neuen Patentschrift:
**10.07.91 Patentblatt 91/28**

(51) Int. Cl.$^5$: **G01R 33/035**

(21) Anmeldenummer: **83112270.0**

(22) Anmeldetag: **06.12.83**

(54) **Vorrichtung zur mehrkanaligen Messung schwacher, sich ändernder Magnetfelder und Verfahren zu ihrer Herstellung.**

(30) Priorität: **22.12.82 DE 3247543**

(43) Veröffentlichungstag der Anmeldung:
**27.06.84 Patentblatt 84/26**

(45) Bekanntmachung des Hinweises auf die
Patenterteilung:
**08.04.87 Patentblatt 87/15**

(45) Bekanntmachung des Hinweises auf die
Entscheidung über den Einspruch:
**10.07.91 Patentblatt 91/28**

(84) Benannte Vertragsstaaten:
**DE FR IT**

(56) Entgegenhaltungen:
**CRYOGENICS, Band 21, Dezember 1981, Seiten 707-710, Guildford, GB; K. SHIRAE et al.: "A new multi-element rf SQUID system and its application to the magnetic vector gradiometer"**

(56) Entgegenhaltungen:
**C.M. Pegrum, C.B. Donaldson:Optimising the design of thin-film DC SQUID gradiometers, SQID'80, Editors: H.D. Halbohm, H. Lübbig, de Gruyter & Co., Berlin, New York, 1980, S. 535-548
J. Appl. Phys. 49 (7), July 1978, M. B: Ketchen, W.M. Goubau, J. Clarke: Superconducting thin-film gradiometer, S. 4111-4116
Appl. Phys. Lett., Vol. 41, No. 7, 1.Okt. 1982. V.J.de Waal, T.M. Klapwijk: Compact integrated DC SQUID gradiometer, S. 669-671
IEEE Transactions on magnetics. Vol. MAG-17, No.1, Jan. 1981, J.M. Jaycox, M.B. Ketchen: Planar coupling scheme for ultra low noise DC SQUIDS, S. 400-403**

(73) Patentinhaber: **Siemens Aktiengesellschaft Wittelsbacherplatz 2 W-8000 München 2 (DE)**

(72) Erfinder: **Hoenig, Eckhardt, Dr. Palmstrasse 1a W-8520 Erlangen (DE)**

EP 0 111 827 B2

**Beschreibung**

Die Erfindung bezieht sich auf eine Vorrichtung zur mehrkanaligen Messung schwacher, sich ändernder Magnetfelder in einem Feldstärkebereich unter $10^{-10}$ T, insbesondere unter $10^{-12}$ T, welche in jedem Kanal ein supraleitendes Quanten-Interferenz- Element (SQUID), ein durch supraleitende Spulen gebildetes Gradiometer sowie supraleitende Verknüpfungsglieder zwischen dem Quanten-Interferenz-Element und dem Gradiometer mit einem Koppeltransformator und Verbindungsleiter enthält, und welche ferner elektronische Einrichtungen zur Auswertung, Verarbeitung und Darstellung der an den Quanten-Interferenz-Elementen gewonnenen Informationen umfaßt. Die Erfindung betrifft ferner ein Verfahren zur Herstellung dieser Meßvorrichtung.

Die Verwendung von supraleitenden Quanten-Interferenz-Elementen, die allgemein als "SQUIDs" (Abkürzung von "Superconducting Quantum Interference Devices") bezeichnet werden, zur Messung sehr schwacher magnetischer Felder ist allgemein bekannt ("J.Phy.E :Sci. Instrum.", Vol. 13, 1980, Seiten 801 bis 813 ; "IEEE Transactions on Electron Devices", Vol. ED-27, No. 10, Oktober 1980, Seiten 1896 bis 1908). Als ein bevorzugtes Anwendungsgebiet für diese Elemente wird deshalb auch die medizinische Technik, insbesondere die Magnetokardiographie und Magnetoenzephalographie angesehen, wobei magnetische Herz- und Gehirnwellen mit Feldstärken in der Größenordnung von 50 pT bzw. 0,1 pT auftreten ("Biomagnetism-Proceedings Third International Workshop on Biomagnetism, Berlin 1980", Berlin/New York 1981, Seiten 3 bis 31).

Eine Vorrichtung zur Messung derartiger biomagnetischer Felder enthält im wesentlichen folgende Komponenten :

1. Ein SQUID, den eigentlichen Feld-Sensor,

2. einen Flußtransformator, eine Spulenanordnung zur Einkopplung des zu untersuchenden Feldes,

3. elektronische Geräte zur Signalerfassung und -verarbeitung,

4. Abschirmungen für das magnetische Erdfeld und externe Störfelder und

5. ein Kryosystem für den Tieftemperaturbereich der Supraleitung. Entsprechende Vorrichtungen sind bekannt (Firma S.H.E. Corporation, San Diego, USA/S.H.E. GmbH, D-5100 Aachen).

Bei entsprechenden einkanalig ausgebildeten Vorrichtungen wird das zu untersuchende Magnetfeld über eine Spulenanordnung aus supraleitendem Draht in den von einem Radiofrequenz (RF)-SQUID gebildeten Kreis mit einem Josephson-Kontakt induktiv eingekoppelt. Dabei sind durch Kombination einer Sensorspule mit einer oder mehreren Kompensationspulen Gradiometer erster bzw. höherer Ordnung ausgebildet. Mit solchen Gradiometern können bei entsprechendem manuellen Abgleich die drei Komponenten eines im Spulenbereich homogenen Magnetfeldes bzw. auch dessen Anteil mit homogenem Gradienten weitgehend unterdrückt und das im Gradiometerbereich noch stark inhomogene biomagnetische Nahfeld selektiv erfaßt werden. Das RF-SQUID ist außerdem mit einem Resonanzschwingkreis induktiv gekoppelt, dessen hochfrequente Spannung in Phase oder Amplitude durch das Eingangssignal moduliert wird. Im allgemeinen wird durch negative Rückkopplung über eine zusätzliche Kompensationsspule der Arbeitspunkt des RF-SQUID festgehalten und der Kompensationsstrom als elektronisch auszuwertendes Signal verwendet.

Die in diesen Anlagen eingesetzten RF-SQUIDs weisen ein charakteristisches Rausch-Signal auf (vgl.z.B. "SQUID-Superconducting Quantum Intefrenz Devices and their Applications", Berlin/ New York 1977, Seiten 395 bis 431). Zur Ermittlung der genannten, extrem schwachen Magnetfelder muß deshalb an den einzelnen Meßpunkten eine Signalmittelwertbildung durch eine Vielzahl von Einzelmessungen vorgenommen werden. Um eine räumliche Feldverteilung zu erhalten, muß außerdem zeitlich nacheinander an verschiedenen Orten des zu untersuchenden Bereiches gemessen werden. Bei diesen Meßverfahren besteht dann die Schwierigkeit, daß über die hierfür erforderliche Meßzeit die Kohärenz der Felddaten nicht mehr gegeben ist und sich außerdem klinisch unzumutbare Meßzeiten ergeben.

Es ist deshalb vorgeschlagen worden, statt der bekannten einkanaligen Messung eine mehrkanalige vorzunehmen, wobei jeder Kanal neben einem RF-SQUID ein abstimmbares supraleitendes Gradiometer und Verknüpfungsglieder zwischen dem SQUID und dem Gradiometer mit einem Koppeltransformator und Verbindungsleitern aufweist. Bei einer entsprechenden Vorrichtung ergibt sich jedoch ein erheblicher, zeitraubender Aufwand hinsichtlich der Abstimmung der einzelnen Kanäle aufeinander. Gemäß der bekannten Vorrichtung sind nämlich das Gradiometer einerseits und das SQUID mit seinem Koppeltransformator andererseits jeweils auf einer eigenen Trägerstruktur angeordnet und werden über lösbare Verbindungsleiter aneinander angeschlossen. Mit einer derartigen Verbindungstechnik läßt sich jedoch eine konstante Abstimmung des jeweiligen Flußtransformators nicht von vornherein gewährleisten. Vielmehr ist vor jeder Messung ein Abgleich aller Kanäle erforderlich, die sich auch untereinander beeinflussen. Außerdem ist bei einer solchen Anordnung eine gegenseitige Störung der RF-Kreise unvermeidlich.

Wenn man auf als Flußtransformatoren gestaltete Gradiometer verzichtet, kann eine RF-Abschirmung erreicht werden. Eine entsprechende mehrkanalige Meßvorrichtung ist aus "Physica", Band 107B, 1981, Seiten 29 und 30 bekannt. Bei dieser Meßvorrichtung sind nämlich zur Flußführung statt der bekannten Flußtransformatoren im wesentlichen rohrförmige Elemente, sogenannte "Flux guides", aus Nb vorgesehen, die jeweils einseitig offen sind und mit denen der Fluß an der gegenüberliegenden weitgehend geschlossenen Stirnseite über Schlitzungen in ein dort angebrachtes RF-SQUID eingekoppelt wird. Sieben derartiger jeweils aus Flußführungselement und RF-SQUID gebildeter Magnetometer sind untereinander beabstandet an einer kreisscheibenförmigen Trägerplatte befestigt, so daß sich eine entsprechende, vielfach auch als "Array" bezeichnete, quasi modular aufgebaute Reihe von diskreten Magnetometern ergibt. Aber selbst wenn man bei dieser bekannten Meßvorrichtung eine andere Flußführung vorsähe, bliebe das erwähnte Abstimmproblem der einzelnen Meßkanäle.

Eine Meßvorrichtung mit drei RF-SQUIDs und nur einem Resonanzkreis auf einer gemeinsamen Trägerstuktur ist zwar bereits aus der Veröffentlichung "Cryogenics", Dezember 1981, Seiten 707 bis 710 bekannt, die den Oberbegriff von Anspruch 1 belegt. Jedoch ist es bei dieser Vorrichtung ein technisches Problem, daß alle Signalkanäle in einem Hochfrequenzkanal mit gegenseitiger Störmöglichkeit zusammengefaßt werden und daß die einzelnen SQUID-Elemente hinsichtlich ihres kritischen Stromes aufeinander abgestimmt sein müssen. Die Zahl der in der Praxis maximal beherrschbaren Elemente wird deshalb bei etwa 10 angesehen.

Neben den genannten RF-SQUIDs mit jeweils einem Josephson-Kontakt sind auch Gleichstrom (DC)-SQUIDs bekannt, welche zwei Josephson-Kontakte umfassen. Diese DC-SQUIDs lassen sich so gestalten, daß sie ein äußerst kleines Rausch-Signal aufweisen ("IEEE Transactions on Magnetics", Vol.MAG-17, No. 1, Januar 1981, Seiten 395 bis 399. Ein derartiged DC-SQUID kann zusammen mit ihm zugeordneten Gradiometerspulen sowie den erforderlichen supraleitenden Verbindungsleitern auf einem eigenen Substrat angeordnet sein, um so eine gute thermische und mechanisme Stabilität sowie eine intrinsische Balance zu erreichen (vgl. "SQUID '80", Berlin/New York 1980, Seiten 535 bis 548). An einen Einsatz eines modular aufgebauten Sysems mit 5 SQUIDs dieses Typs zur Messung biomagnetischer Felder ist gedacht. Zwar ist bei dieser Vorrichtung eine gegenseitige RF-Störung nicht zu befürchten, jedoch ist auch hier das erwähnte Abstimmproblem gegeben.

Aufgabe der vorliegenden Erfindung ist es, unter Verwendung von DC-SQUIDs die vorgeschlagene, eingangs genannte Vorrichtung zur mehrkanaligen Messung schwacher, sich ändernder Magnetfelder dahingehend zu verbessern, daß mit ihr die räumliche Feldverteilung von biomagnetischen Feldern während zumutbarer Meßzeiten ermittelt werden kann, wobei eine weitgehende Kohärenz der Felddaten gewährleistet ist.

Diese Aufgabe wird erfindungsgemäß mit den im Anspruch 1 aufgeführten Maßnahmen gelöst.

Bei dieser Ausgestaltung der Meßvorrichtung ist somit eine parallele, d.h. gleichzeitige Registrierung der Feldwerte von verschiedenen Orten aus mit Hilfe einer Reihe von supraleitenden Gradiometer-Spulen ermöglicht, die mit einer entsprechenden Reihe von DC-SQUIDs zu einem starren System verknüpft sind. Hiermit läßt sich vorteilhaft die Meßzeit entsprechend der Anzahl der Kanäle reduzieren. Außerdem ist bei dem erfindungsgemäßen Aufbau unter Verwendung von Dünnfilmstrukturen nur ein einmaliger Abgleich erforderlich.

Vorteilhafte Ausgestaltungen der Meßvorrichtung nach der Erfindung bzw. ein Verfahren zur Herstellung einer solchen Meßvorrichtung gehen aus den Unteransprüchen hervor.

Zur weiteren Erläuterung der Erfindung und deren in den Unteransprüchen gekennzeichneten Weiterbildungen wird auf die Zeichnung Bezug genommen, in deren Figur 1 ein Schaltungsschema einer Meßvorrichtung nach der Erfindung angedeutet ist. Die Figur 2 zeigt schematisch eine Trägerstruktur dieser Vorrichtung mit SQUIDs und Gradiometern, während in den Figuren 3 und 4 ein Träger für einen entsprechenden SQUID-Chip veranschaulicht ist. In Figur 5 ist ein weiterer Aufbau einer erfindungsgemäßen Vorrichtung dargestellt, von der in den Figuren 6 und 7 jeweils als Detail eine Verbindung ihrer Leiterbahnen gezeigt ist.

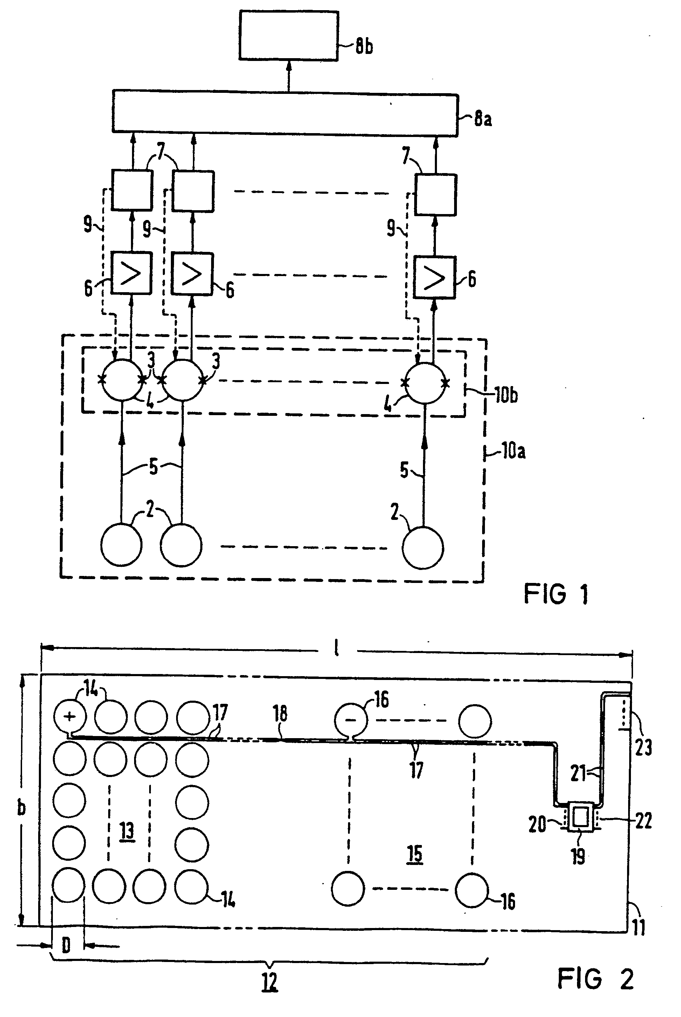

Gemäß dem in Figur 1 angedeuteten Schaltungsschema der Meßvorrichtung nach der Erfindung ist eine vorbestimmte Anzahl N paralleler Meßkanäle vorgesehen. Jeder Kanal enthält dabei ein supraleitendes Gradiometer 2 und ein mit zwei Josephson-Kontakten 3 ausgestattetes DC-SQUID 4, ein supraleitendes Verknüpfungsglied 5 zur Verbindung des Gradiometers mit dem SQUID 4, ferner einen beispielsweise ebenfalls gekühlten Vorverstärker 6 sowie einen sogenannten "Lock-in" -Verstärker 7.

Die aus den Lock-in-Verstärkern 7 entnommenen N Rohsignale werden dann einem gemeinsamen elektronischen Datenverarbeitungs- und Steuerungssystem 8a zur Weiterverarbeitung und einer Ausgabeeinheit 8b zur Darstellung zugeführt. Eine Rückkopplung in den Kanälen an die jeweiligen SQUIDs mit den den Look-in-Verstärkern 7 entnommenen Signalen ist durch gepunktete Linien 9 angedeutet. Die Signalübertragungsrichtungen sind in der Figur durch Pfeile an den den entsprechenden Linien veranschaulicht.

Wie in der Figur ferner durch gestrichelte Linien dargestellt ist, sollen gemäß der Erfindung die Gradiometer 2, die SQUIDs 4 sowie die zwischen ihnen erforderlichen Verbindungsglieder 5 auf einer gemeinsamen, starren Trägerstruktur angeordnet sein. Diese Trägerstruktur ist in der Figur durch eine mit 10a bezeichnete, gestrichelte Linie angedeutet. In entsprechender Weise ist ferner veranschaulicht, daß sich die SQUIDs 4 mit ihren zugeordneten Dünnfilmtransformatoren auf einem Trägerplättchen (Chip) 10b befinden, das fest auf der Trägerstruktur 10a angeordnet ist.

Bekanntlich ergeben sich für eine vorbestimmte Entfernung zwischen einer Gradiometer-Spule 2 und einer von ihr zu detektierenden Magnetfeldquelle z.B. im Herzen bestimmte optimale Abmessungen der Gradiometer-Spulen hinsichtlich der Empfindlichkeit ("Journal of Magnetism and Magnetic Materials", Band 22, 1982, Nr. 2, Seiten 129 bis 201). Für verschieden weit entfernte Feldquellen ist aber eine Änderung der Abmessungen der einzelnen Gradiometer-Spulen praktisch nicht möglich. Um dennoch eine Anpassung an den Abstand zu der jeweils zu detektierenden Feldquelle vornehmen zu können, lassen sich bei der Meßvorrichtung nach der Erfindung vorteilhaft die an den einzelnen Gradiometer-Spulen 2 erzeugten Signale in vorbestimmter Weise zusammenfassen. Dementsprechend kann beispielsweise bei dem in Figur 1 angedeuteten Ausführungsbeispiel eine Zusammenfassung der Signale von jeweils zwei oder drei der Gradiometer-Spulen 2 vorgenommen werden. Die Signalzusammenfassung erfolgt dabei vorzugsweise im Bereich der für alle Spulen gemeinsamen Elektronik 8a durch entsprechende Verknüpfungsschaltungen.

Außerdem werden vorteilhaft die Abmessungen jeder Gradiometer-Spule, bei runder Gestalt deren Durchmesser, dem Abstand zu der nächstliegenden, zu detektierenden Magnetfeldquelle hinsichtlich optimaler Ortsauflösung angepaßt. So wählt man z.B. für magnetoenzophalographische Untersuchungen im allgemeinen einen Durchmesser von etwa 2 cm, der für Messungen von Quellen in der Hirnrinde optimal ist. Um auch eine Anpassung an tieferliegende Magnetfeldquellen zu ermöglichen, werden dann durch die erwähnte Zusammenfassung der Signale einzelner Gradiometer-Spulen Spulenverhältnisse eingestellt, die weitgehend effektiven Spulenabmessungen entsprechen, die für diese größeren Entfernungen zwischen Magnetfeldquelle und Spule optimal sind.

Einzelheiten der Gradiometer- und SQUID-Anordnung auf entsprechenden Trägerstrukturen sind in den weiteren Figuren schematisch dargestellt.

Die einfachste Anordnung von Feldsensoren ist eine Reihe von Gradiometern nullter Ordnung, d.h. eine ebene Anordnung nebeneinanderliegender flacher Zylinderspulen aus supraleitendem Draht. Für Messungen mit einer solchen Reihe ohne zusätzliche Kompensation von Fremdfeldern ist zwar eine verhältnismäßig aufwendige Abschirmung erforderlich, jedoch läßt sich eine derartige Gradiometer-Reihe verhältnismäßig einfach herstellen.

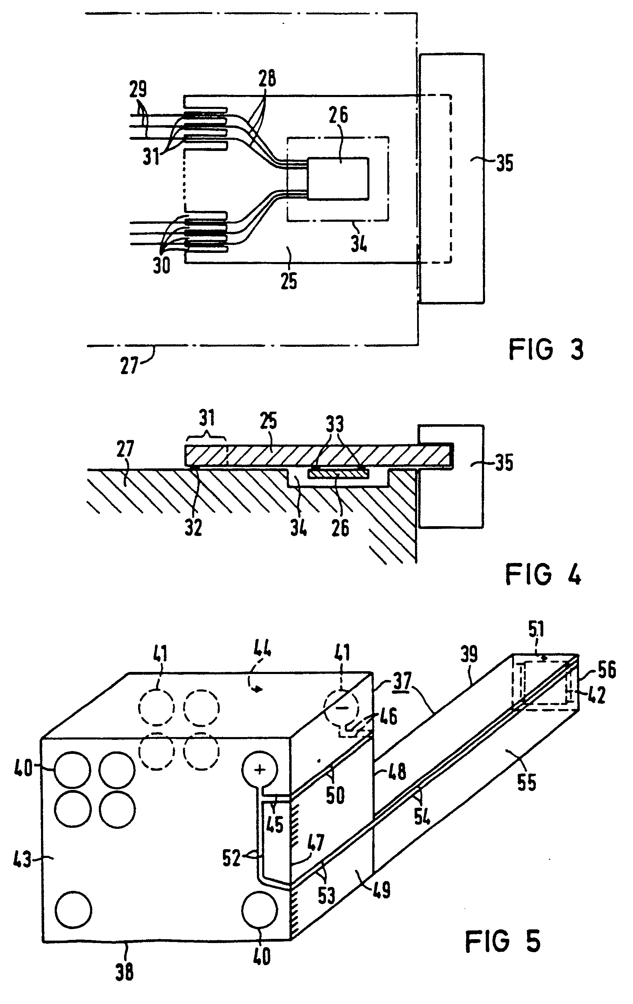

Geringere Anforderungen hinsichtlich der Abschirmung stellen Gradiometer erster Ordnung, wobei zwei Ausführungsformen in den Figuren 2 und 5 angedeutet sind. Während die in Figur 2 angedeutete Gradiometer-Reihe planar gestaltet ist, handelt es sich bei der in Figur 5 gezeigten Gradiometer-Reihe um eine Anordnung in zwei Ebenen.

Gemäß Figur 2 ist auf einer ebenen Trägerstruktur 11, beispielsweise einer Quarz- oder Siliziumplatte von etwa 10 mm Dicke, 12 cm Breite b und 30 cm Länge l eine planare Gradiometer-Reihe, auch Gradiometer-Feld (Array) genannt, aufgebracht. Diese mit 12 bezeichnete Gradiometer-Reihe wird durch eine Reihe 13 von Detektionsspulen 14, durch eine Reihe 15 mit einer entsprechenden Anzahl von Kompensationsspulen 16 sowie durch entsprechende Verbindungsleitungen 17 gebildet. In der Figur sind nur einige der Flachspulen und Verbindungsleitungen ausgeführt. Jede der Reihen 13 und 15 besteht beispielsweise aus 4 mal 5 einzelnen supraleitenden Flachspulen mit jeweils einer Windung, deren Durchmesser D etwa in der Größenordnung des Abstandes von dem zu untersuchenden Objekt liegt und somit beispielsweise einige Zentimeter beträgt. Da, wie in der Figur durch ein "+" und "–" – Zeichen angedeutet, der Wickelsinn der Detektionsspulen 14 entgegengesetzt zu dem Wickelsinn der Kompensationsspulen 16 ist, muß zwischen den Flachspulenreihen 13 und 15 in den zwischen ihnen liegenden Verbindungsleitungen 17 jeweils ein Überkreuzungspunkt 18 ausgebildet sein.

Neben der in Figur 2 gezeigten Anordnung der Detektionsspulen 14 bzgl. der Kompensationsspulen 16 läßt sich auch eine andere Lage der einzelnen Spulen vorsehen. So können beispielsweise bei einer äußeren Kompensation die Detektionsspulen von einem Kranz aus den einzelnen Kompensationsspulen umschlossen sein.

Das Kompensations-Flachspulenfeld 15 kann vorteilhaft auch durch ein kleineres Feld von Spulen mit entsprechend erhöhter Windungszahl ersetzt werden. Dies läßt sich beispielsweise durch ein Lithographie-Verfahren mit Hilfe einer isolierenden Zwischenschicht realisieren.

Auf der Trägerstruktur 11 befindet sich ferner ein Plättchen (Chip) 19 mit einer der Gradiometer-Anzahl entsprechenden Anzahl von DC-SQUIDs einschließlich supraleitender Koppeltransformatoren und Modulationsspulen mit Anschlüssen. Im allgemeinen wählt man als Chip-Material Silizium. Die Koppeltransformatoren können in bekannter Weise als Flachspulen ausgebildet sein (vgl. "IEEE Trans.Magn.", Vol. MAG-17, No. 1, Januar 1981, Seiten 400 bis 403). An Anschlußpunkten 20 sind an diese Koppeltransformatoren die jeweiligen Verbindungsleitungen 17 zur Zuführung der in den Gradiometer-Spulen registrierten Feldsignale supraleitend angeschlossen.

Die an den einzelnen SQUIDs abgenommenen Signale werden dann über normalleitende Eingangs-/Ausgangsleitungen 21, die an entsprechenden Anschlußpunkten 22 mit dem DC-SQUID-Chip 19 verbunden sind, einem Vielfach-Kontaktstreifen 23 zugeführt, an dem dann die Verstärker der jeweiligen Kanäle angeschlossen sind.

Bei Wahl verschiedener Trägermaterialien für die Trägerplatte 11 und das Chip 19 kann im Fall einer Lötverbindungstechnik an den Anschlüssen 20 vorteilhaft ein besonderer Chip-Träger verwendet werden, um unterschiedliche thermische Ausdehnungen zu vermindern oder zu vermeiden. Bei Verwendung eines solchen Chip-Trägers ist außerdem ein verhältnismäßig einfacher Chip-Austausch ermöglicht. Ein Ausführungsbeispiel für einen entsprechenden Chip-Träger geht aus der Aufsicht bzw. dem Längsschnitt der Figuren 3 und 4 hervor. Der mit 25 bezeichnete Chip-Träger besteht vorteilhaft aus dem gleichen Material wie das auf ihm angeordnete, die SQUIDs und deren DünnfilmTransformatoren tragende Chip 26, d.h. z.B. aus Si, während die die Gradiometer tragende Platte 27 z.B. aus Quarz besteht. Zum Abbau thermischer Spannungen an den Anschlüssen zwischen den auf dem Chip-Träger verlaufenden Leiterbahnen 28 und den zu den Gradiometerspulen führenden Leiterbahnen 29 auf der Trägerplatte 27 ist der Chip-Träger 25 zwischen den Anschlüssen tief eingesägt. Es entsteht so an der Anschlußseite eine kammartige Struktur mit zwischen Einschnitten 30 ausgebildeten Stegen 31, auf deren freien Enden die Leiterbahnen 28 und 29 durch Verlötungen 32 miteinander verbunden sind.

Wie insbesondere aus dem Längsschnitt der Figur 4 ersichtlich, ist das Chip 26 auf der Unterseite des Chip-Trägers 25 durch Verlötungen 33 der Leiterbahnen befestigt. In der Quarz-Trägerplatte 27 ist deshalb eine entsprechende Vertiefung 34 vorgesehen. Ferner kann der Chip-Träger 25 auf seiner den Gradiometerspulen abgewandten Seite über die Trägerplatte 27 ein Stück weit hinausragen. Es ist so möglich, an dieser Seite des Trägers 25 einen Stecker 35 zum Anschluß der SQUIDs an nachfolgende Verstärker direkt an entsprechenden normalleitenden Leiterbahnen angreifen zu lassen.

Die Herstellung einer Meßvorrichtung nach der Erfindung mit der gezeigten ebenen Trägerplatte wird nachfolgend unter Bezugnahme auf Figur 2 erläutert. Hierzu wird zunächst auf dieser Trägerplatte 11 die planare Gradiometer-Reihe 12 mit den Detektionsspulen 14 und den Kompensationsspulen 16 in einem an sich bekannten Planarlithographie-Schritt in Form von supraleitenden Dünnfilm-Spulenfeldern beispielsweise aus Blei realisiert. Bei diesem Verfahrensschritt können auch die Verbindungsleitungen 17 der einzelnen Spulen untereinander sowie deren Überkreuzungspunkte 18 als Dünnfilm-Struktur hergestellt werden.

Unabhängig davon wird die DC-SQUID-Reihe beispielsweise aus Niob nach den in den DE-A-31 28 982, 31 29 000, 32 20 211 und 32 20 251, veröffentlicht jeweils am 10.2.1983, 17,2.1983, 1.12.1983 und 1.12.1983, beschriebenen Verfahren erstellt. In weiteren Schritten werden dann die supraleitenden Koppeltransformatoren und Modulationsspulen mit Anschlüssen z.B. aus Blei in einer aus der Herstellung integrierter Schaltungen bekannten Technik auf dem Silizium-Chip 19 in Form einer mehrlagigen Dünnfilm-Struktur aufgebracht. Das so hergestellte DC-SQUID-Chip wird anschließend fest auf der mit der Gradiometer-Reihe versehenen Trägerplatte 11 angeordnet, insbesondere nach einem bekannten Verfahren aufgelötet ("J.Electrochem.Soc. : Solid-State Science and Technology", April 1982, Seiten 859 bis 864). Ein Auflöten hat nämlich den großen Vorteil, daß praktisch keine dreidimensionalen Leiterschleifen entstehen, die den Abgleich der Gradiometer erschweren.

Schließlich wird noch in einem weiteren Schritt die Gradiometer-Reihe 12 mit den auf dem Chip 19 befindlichen DC-SQUIDs verbunden. Hierzu sind beispielsweise Lötverbindungen auf der Basis supraleitender Blei-Legierungen möglich.

Nach diesem Aufbau der Gradiometer-Reihe 12 und der an sie angeschlossenen DC-SQUIDs des Chips 19 auf der Trägerplatte 11 wird ein einmaliger Abgleich der Gradiometer-Spulen vorgenommen. Hierzu kann insbesondere ein Laserstrahl verwendet werden, mit dem die Breite der einzelnen Spulenwindungen zu verringern ist.

Bei Ausbildung der Gradiometer als Dünnfilm-Struktur in mehreren Ebenen mit Dünnfilm-Verbindungsleitungen auf einer dann orthogonalen Fläche wird ein Abgleich vorteilhaft auf dieser orthogonalen Fläche vorgenommen. Der Abgleich erfolgt zweckmäßig nach Testmessungen in homogenen Magnetfeldern und homogenen Gradientenfeldern.

Da axial aufgebaute Gradiometer bekanntlich eine bessere Richtcharakteristik aufweisen als planare Gradiometer, kann vorteilhak eine Planarstruktur in mehreren Ebenen vorgesehen werden. Ein Ausführungsbeispiel einer entsprechenden Gradiometerstruktur erster Ordnung geht aus der in Figur 5 gezeigten Schrägansicht schematisch hervor. Dabei sind in der gewählten Ansicht durch die Trägerstuktur abgeschattete Teile teilweise durch gestrichelte Linien angedeutet. Die Trägerstruktur 37 setzt sich im wesentlichen aus zwei quaderförmigen, starr aneinanderzufügenden Teilen 38 und 39 zur Aufnahme von Gradiometer-Spulen 40 und 41 bzw. eines DC-SQUID-Chips 42 zusammen. In der Figur sind nur einige der Gradiometer-Spulen mit ihren entsprechenden Verbindungsleitungen veranschaulicht.

Auf der vorderen Flachseite 43 des größeren Trägerstrukturteils 38, beispielsweise eines Quarz-Prismas, sind die Detektionsspulen 40 angeordnet, welche z.B. den Spulen 14 nach Figur 2 entsprechen, während die rückwärtige Flachseite 44 dieses Quarz-Prismas die den Spulen 16 nach Figur 2 entsprechenden Kompensationsspulen 41 trägt. Jede Detektionsspule 40 ist mit ihrer zugeordneten Kompensationsspule 41 auf der gegenüberliegenden Flachseite über die Kanten des Prismas verbunden. Hierzu dienen Leiterbahnen 45 und 46 von wenigen Mikrometern Abstand auf den Flachseiten 43 bzw. 44, die zu den Kanten 47 bzw. 48 der zu den Flachseiten 43 und 44 orthogonalen Flachseite 49 des Quarz-Prismas 38 führen, sowie Leiterbahnen 50, die sich über die orthogonale Flachseite 49 zwischen den Kanten 47 und 48 erstrecken.

Mit dem mit den Gradiometer-Spulen 40 und 41 versehenen Quarz-Prisma 38 ist auf dessen rückwärtiger Flachseite 44 das weitere, säulenförmige Trägerstukturteil 39, beispielsweise ebenfalls ein Quarz-Prisma, starr verbunden. Dieses säulenförmige Prisma hat einen der Größe des DC-SQUID-Chips 42 angepaßten Querschnitt. Dieses Chip wird dabei zum Beispiel auf der der Flachseite 44 abgewandten Seite 51 des säulenförmigen Quarz-Prismas 39 angeordnet. Zur Verbindung der DC-SQUIDs dieses Chips 42 mit den Gradiometer-Spulen sind zunächst den Leiterbahnen 45 entsprechende Leiterbahnen 52 von den einzelnen Detektionsspulen 40 bis zu der Kante 47 der Flachseite 43 vorgesehen. An dieser Kante sind die Leiterbahnen 52 mit Leiterbahnen 53 verbunden, die sich über die orthogonale Flachseite 49 bis zu der Kante 48 erstrecken und die den Leiterbahnen 50 entsprechen. Über entsprechende Leiterbahnen 54, welche auf der in derselben Ebene wie die orthogonale Flachseite 49 liegenden Seitenfläche 55 des säulenförmigen Quarz-Prismas 39 aufgebracht sind, ist die Verbindung zwischen der Kante 48 und der Kante 45 mit der das Chip 42 tragenden Seite 51 des Prismas 39 geschaffen.

Neben der in der Figur 5 dargestellten Anordnung des Chips 42 auf der Seite 51 kann das Chip 42 auch auf der Seitenfläche 55 befestigt werden. Hierbei lassen sich vorteilhaft Leiterbahnenverbindungen an der Kante 56 einsparen.

Die Anordnung der Detektionsspulen 40 und der Kompensationsspulen 41 in zwei parallelen Ebenen einer Trägerstruktur wie z.B. gemäß Fig. 5 führt dazu, daß orthogonale Ebenen vorhanden sind, die vorteilhaft dazu verwendet werden können, daß man in diesen Ebenen zusätzliche Detektionsschleifen, beispielsweise in Dünnfilmtechnik, anbringen kann, mit denen man die drei Vektorkomponenten des Magnetfelds zum Zwecke einer adaptiven Filterung bestimmen kann (vgl. "Rev.Sci.Instrum.", Vol. 53, No. 12, 1982, Seiten 1815 bis 1845, insbesondere Seite 1836).

Um den Aufwand für die Lithographie zur Herstellung des Gradiometers zu verringern, kann man bei verringerten Ansprüchen an die mechanische Stabilität auch supraleitende Verbindungen vorsehen, die aus mit Pb-Inüberzogenem Cu-Draht gebildet werden, wobei an verstärkten Kontakten Feinlötungen möglich sind.

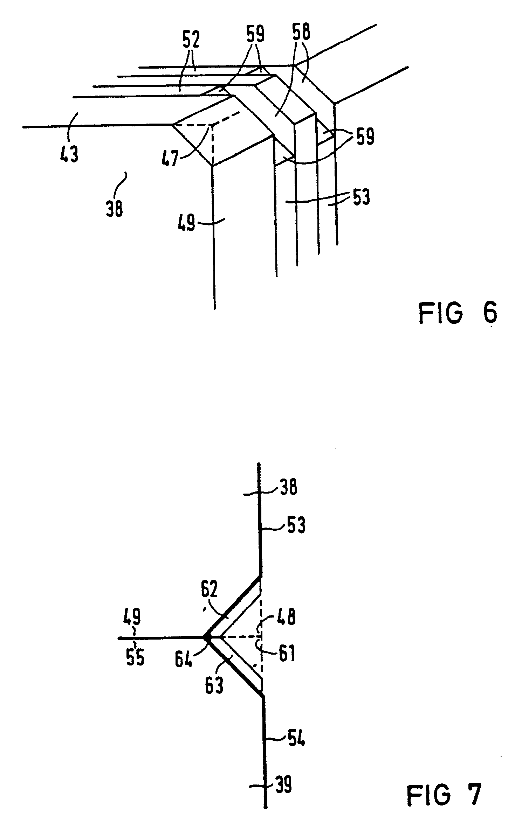

Die Verbindung der Leiterbahnen 52 mit den Leiterbahnen 53 an der Kante 47 wird vorteilhaft entsprechend einem in der DE-A-32 46 661, veröffentlicht am 20.6.1984, mit dem Titel : "Verfahren zum Herstellen von um eine Außenkante führenden elektrischen Leitungen", vorgeschlagenen Verfahren vorgenommen und ist in der Schrägansicht der Figur 6 für zwei Leiterbahnverbindungen angedeutet. Dabei sind mit Figur 5 übereinstimmende Teile mit den gleichen Bezugszeichen versehen. Danach wird in die Kante 47 zwischen den beiden Flachseiten 43 und 49 zunächst senkrecht eine Nut 58 an jeder vorbestimmten Verbindungsstelle eingearbeitet, bevor auf die Flachseiten einschließlich auf die Wände der Nuten ein dünner Film aus dem Material der Leiterbahnen aufgebracht wird. Anschließend werden in bekannter Lithographietechnik die Leiterbahnen durch Entfernung der überflüssigen Teile der aufgebrachten Filme ausgebildet. Außerdem wird die Kante 47 leicht abgeschrägt, um dort schärfere Begrenzungen zwischen beschichteten und nicht beschichteten Teilen zu erhalten. Zur Verbesserung der Verbindung zwischen den Leiterbahnen 52 und 53 kann zusätzlich noch zwischen den jeweiligen Übergangsstellen zu den in den Nuten 58 abgeschiedenen Teilen eine Verlötung am Nutengrund vorgenommen werden. In der Figur sind dementsprechende Lötstellen mit 59 bezeichnet. Supraleitendes Blei-Indium-Lot kommt hierzu insbesondere in Frage.

In entsprechender Weise können auch die Verbindungen der Leiterbahnen 50 mit den Leiterbahnen 45 und 46 sowie die Verbindungen an der Kante 56 erstellt werden.

In Figur 7 ist schematisch der Übergang der Leiterbahnen von dem die Gradiometerspulen 40 und 41 tragenden Prisma 38 auf das das DC-SQUID-Chip 42 tragende Prisma 39 als Schnitt durch den entsprechenden Teil des Aufbaus nach Figur 5 schematisch veranschaulicht. Um die Leiterbahnen 53 mit den Leiterbahnen 54 zu verbinden, werden diese zunächst an den jeweiligen Kanten 48 bzw. 61 entsprechend dem in Figur 6 angedeuteten Verfahren mit Verbindungsstücken in Nuten 62 bzw. 63 versehen. Anschließend werden die Seiten 49 und 55 der beiden Prismen 38 und 39 so aneinandergefügt, daß die Leiterteile in diesen Nuten 62 und 63 aneinanderstoßen. An dieser Stelle wird schließlich noch eine Verlötung 64 z.B. mit einer Blei-Legierung vorgenommen, nachdem die Filmbeläge in den Nuten galvanisch verstärkt werden.

Bei den in den Figuren gezeigten Ausführungsbeispielen von Meßvorrichtungen nach der Erfindung wurde auf eine zeichnerische Darstellung von Maßnahmen zur Abschirmung der DC-SQUIDs gegen magnetische Störfelder aus Gründen der Übersichtlichkeit verzichtet. Entsprechende Maßnahmen sind allgemein bekannt. So kann man zur Abschirmung eines SQUID-Chips beispielsweise die SQUIDs auf dem Chip einzeln durch geschlossene supraleitende Ringstrukturen umgeben. Auch eine Beschichtung der Chip- Rückseite mit supraleitendem Material ist möglich. Für den Fall der Verwendung eines besonderen Chip-Trägers läßt sich auch dieser mit einer entsprechenden Schicht auf seiner Rückseite versehen. In diesem Fall kann ferner der Chip und sein Chip-Träger auch mit einer bis auf eine Öffnung an den Zuleitungen geschlossenen supraleitenden Hülse umgeben werden.

Sollen Gradiometer zweiter Ordnung ausgebildet werden, so können vorteilhaft zwei einzelne abgeglichene Blöcke entsprechend dem Prisma 38 nach Figur 5 aneinandergefügt und deren Leiter entsprechend dem anhand der Figuren 6 und 7 beschriebener Verfahren über die Kanten miteinander verbunden werden.

Für die Ausbildung der Trägerstruktur der Meßvorrichtung nach der Erfindung bestehen also insbesondere die folgenden 3 Möglichkeiten :

a) Es wird ein gemeinsamer Trägerkörper vorgesehen, auf den die Dünnfilm-Magnetometer-Reihen und Dünnfilm-Verbindungsleitungen für ein vollständiges Gradiometer 1. oder 2. Ordnung einschließlich eines SQUID-Chips auf einem Chip-Träger aufgebracht werden.

b) Es werden zwei komplette Gradiometer 1. Ordnung gemäß der vorstehend unter a) genannten Möglichkeit realisiert, die dann zu einer mechanisch festen Struktur zusammengesetzt werden, um so ein Gradiometer 2. Ordnung aus zwei Teilen, auch Moduln genannt, auszubilden.

c) Zwei starre Dünnfilm-Magnetometer-Reihen und ein SQUID-Chip auf einem Chip-Träger werden zu einem mechanischen festen Aufbau zusammengefügt und untereinander durch supraleitend abgeschirmte Drahtbündel supraleitend verbunden.

Bei den in den Figuren gezeigten Ausführungsformen der Gradiometer-Spulen wurde von einer kreisförmigen Gestalt der einzelnen Windungen ausgegangen.

Gegebenenfalls können die Windungen jedoch zur Optimierung der Flächenausnutzung bei Minimalisierung der gegenseitigen Kopplung von der Kreisform abweichend gestaltet werden.

**Patentansprüche**

1. Vorrichtung zur mehrkanaligen Messung schwacher, sich ändernder Magnetfelder in einem Feldstärkebereich unter $10^{-10}$ T, welche in jedem Kanal

– ein supraleitendes Quanten-Interferenz-Element (SQUID) (4),
– ein durch supraleitende Spulen (2) gebildetes Gradiometer sowie
– supraleitende Verknüpfungsglieder (5) zwischen dem Quanten-Interferenz-Element (4) und dem Gradiometer mit einem Koppeltransformator und Verbindungsleitern enthält und welche ferner elektronische Einrichtungen (6, 7, 8a, 8b) zur Auswertung, Verarbeitung und Darstellung der an den Quanten-Interferenz-Elementen (4) gewonnenen Informationen umfaßt, **dadurch gekennzeichnet,** daß eine starre Trägerstruktur (10a, 11, 27, 37) vorgesehen ist, auf der gemeinsam

a) die eine Reihe (Array) bildenden supraleitenden Gleichstrom-Quanten-Interferenz-Elemente (DC-SQUIDs 4), und
b) jeweils als Dünnfilm-Strukturen in einer oder mehreren Ebenen

– die den Gleichstrom-Quanten-Interferenz-Elementen zugeordneten, planar gestalteten und mindestens eine Reihe (Array) bildenden Gradiometer-Spulen (2 ; 14, 16 ; 40, 41) sowie
– die supraleitenden Verknüpfungsglieder (5) angeordnet sind, wobei die Gradiometer-Spulen und die Verbindungsleiter (17, 29, 45, 46, 50, 52, 53) auf der Trägerstruktur abgeschieden sind.

2. Meßvorrichtung nach Anspruch 1, dadurch gekennzeichnet, daß die Gleichstrom-Quanten-Interferenz-Elemente (4) auf einem gemeinsamen Trägerplättchen (Chip 10b, 19, 26, 42) angeordnet sind und dieses Trägerplättchen auf der Trägerstruktur (10a, 11, 27, 37) starr befestigt ist.

3. Meßvorrichtung nach Anspruch 2 mit einem Gradiometer 1 oder höherer Ordnung, gekennzeichnet durch eine Trägerstruktur (11) mit einem einzigen Trägerteil für die Gradiometer-Spulen (14, 16), die Verknüpfungsglieder (17) und das Trägerplättchen (Chip 19) der Gleichstrom-Quanten-Interferenz-Elemente.

4. Meßvorrichtung nach einem der Ansprüche 1 bis 3, dadurch gekennzeichnet, daß alle Gradiometer-Spulen (14, 16) auf einer gemeinsamen Flachseite der Trägerstruktur (11) nebeneinander angeordnet sind (Figur 2).

5. Meßvorrichtung nach Anspruch 1 oder 2, dadurch gekennzeichnet, daß die Trägerstruktur (37 aus mehreren Teilen (38, 39) zusammengesetzt ist (Figur 5).

6. Meßvorrichtung nach Anspruch 5 mit einem Gradiometer 2. Ordnung, gekennzeichnet durch eine Trägerstruktur mit zwei Trägerteilen, die jeweils mit einem Gradiometer 1. Ordnung versehen sind.

7. Meßvorrichtung nach einem der Ansprüche 1 bis 6, gekennzeichnet durch eine Trägerstruktur (10a, 11, 27, 37) aus Quarz- oder Silizium-Teilen.

8. Meßvorrichtung nach einem der Ansprüche 1 bis 7, dadurch gekennzeichnet, daß die Gradiometer-Spulen (2 ; 14, 16 ; 40, 41) als eine Reihe (13) von Detektionsspulen (14 ; 40) und als eine Reihe (15) von Kompensationsspulen (16 ; 41) auf der gemeinsamen Trägerstruktur (10a, 11, 37) angeordnet sind.

9. Meßvorrichtung nach Anspruch 8, dadurch gekennzeichnet, daß die Detektionsspulen (14, 40) im Vergleich zu den ihnen zugeordneten Kompensationsspulen (16, 41) verschiedene Windungszahl und/oder verschiedene Flächen haben.

10. Meßvorrichtung nach Anspruch 8 oder 9, dadurch gekennzeichnet, daß die Detektionsspulen (40) und die Kompensationsspulen (41) auf verschiedenen parallelen Flachseiten (43, 44) der Trägerstruktur (37) angeordnet sind (Figur 5).

11. Meßvorrichtung nach Anspruch 10, dadurch gekennzeichnet, daß die Gleichstrom-Quanten-Interferenz-Elemente (SQUID-Chip 42) auf einer Flachseite (51) der Trägerstruktur (37) angeordnet sind, die in einer anderen Ebene als die Flachseiten (43, 44) der Gradiometer-Spulen (40, 41) liegt.

12. Meßvorrichtung nach Anspruch 10 oder 11, dadurch gekennzeichnet, daß die Verbindungen zwischen den auf den parallelen Flachseiten (43, 44) befindlichen Gradiometer-Spulen (40, 41) als zwischen den Kanten (47, 48) dieser Flachseiten (43, 44) verlaufende Dünnfilm-Leiter (50) ausgebildet sind.

13. Meßvorrichtung nach einem der Ansprüche 10 bis 12, dadurch gekennzeichnet, daß die Verbindungen zwischen den Gradiometer-Spulen (40) und den Gleichstrom-Quanten-Interferenz-Elementen (SQUID-Chip 42) als zwischen den Kanten (47, 48, 56) der diese Teile tragenden Flachseiten (43, 51) verlaufende Dünnfilm-Leiter (53, 54) ausgebildet sind.

14. Meßvorrichtung nach Anspruch 12 oder 13, dadurch gekennzeichnet, daß die Verbindung der supraleitenden Leiterteile (45, 46, 50, 52 bis 54) an den Kanten (47, 48, 56, 61) durch Lötungen (59, 60, 64) mit supraleitendem Material in Nuten (58, 62, 63) ausgebildet sind.

15. Meßvorrichtung nach Anspruch 14, dadurch gekennzeichnet, daß die mit den Nuten (58, 62, 63) versehenen Kanten (47, 48, 56, 61) abgeschrägt sind.

16. Meßvorrichtung nach einem der Ansprüche 1 bis 15, dadurch gekennzeichnet, daß die Abmessungen (Durchmesser D) der einzelnen Gradiometer-Spulen (2 ; 14, 16 ; 40, 41) der nächstliegenden zu detektierenden Magnetfeldquelle angepaßt sind und daß Mittel zur Zusammenfassung der Signale einzelner Gradiometer-Spulen zu einem gemeinsamen Signal einer Gruppe von Gradiometer-Spulen in Abhängigkeit von der Entfernung der jeweils zu detektierenden Magnetfeldquelle vorgesehen sind.

17. Meßvorrichtung nach Anspruch 16, dadurch gekennzeichnet, daß zur Zusammenfassung der Signale einzelner Gradiometer-Spulen (2 ; 14, 16 ; 40, 41) die entsprechenden Kanäle in der elektronischen Einrichtung (8a) zur Auswertung und Verarbeitung der an den Quanten-Interferenz- Elementen abgenommenen Informationen zusammengeschaltet sind.

18. Meßvorrichtung nach Anspruch 2, dadurch gekennzeichnet, daß das Trägerplättchen (26) mittelbar über einen Zwischenträger (Chip-Träger 25) auf der Trägerstruktur (27) befestigt ist (Figur 4).

19. Meßvorrichtung nach Anspruch 18, dadurch gekennzeichnet, daß der Zwischenträger (Chip-Träger 25) im Bereich der supraleitenden Leiteranschlüsse mit Schlitzen (30) versehen ist.

20. Verfahren zur Herstellung einer Meßvorrichtung nach einem der Ansprüche 2, 18, 19, dadurch gekennzeichnet, daß zunächst auf der Trägerstruktur (10a, 11, 27, 37) die Gradiometer-Spulen (2 ; 14, 16, 40, 41) zusammen mit den untereinander und zu den auf dem Trägerplättchen (Chip 10b, 19, 25 und 26, 42) befindlichen Gleichstrom-Quanten-Interferenz-Elementen (4) verlaufenden Verbindungsleitern (5, 17, 29, 45, 46, 50, 52 bis 54) in einer Planarlithographie-Technik aufgebracht werden, daß unabhängig davon auf dem Trägerplättchen entsprechend einer Technik zur Herstellung integrierter Schaltungen (IC-Technik) die Gleichstrom-Quanten-Interferenz-Elemente (4) ausgebildet werden und daß anschließend das mit den Gleichstrom-Quanten-Interferenz-Elementen versehene Trägerplättchen auf die Trägerstuktur aufgebracht und angeschlossen wird.

## Claims

1. Device for the multi-channel measurement of weak changing magnetic fields in a field strength region under $10^{-10}$ T, which contains in each channel
- a superconducting quantum interference element (SQUID) (4),
- a gradiometer formed by superconducting coils (2) as well as
- superconducting connecting elements (5) between the quantum interference element (4) and the gradiometer with a coupling transformer and connection conductors and which, moreover, comprises electronic devices (6, 7, 8a, 8b) for the evaluation, processing and representation of the information obtained at the quantum interference elements (4), characterized in that a rigid supporting structure (10a, 11, 27, 37) is provided, on which there are arranged together
   a) the superconducting direct current quantum interference elements (DC-SQUIDs 4) forming a series (array), and
   b) in each case as thin-film structures in one or several planes
- the gradiometer coils (2 ; 14, 16 ; 40, 41) which are associated with the direct current quantum interference elements, are constructed in a planar manner and form at least one series (array) as well as

– the superconducting connecting elements (5), whereby the gradiometer coils and the connection conductors (17, 29, 45, 46, 50, 52, 53) are deposited on the supporting structure.

2. Measuring device according to claim 1, characterized in that the direct current quantum interference elements (4) are arranged on a common small supporting plate (chip 10b, 19, 26, 42) and this small supporting plate is fastened rigidly on to the supporting structure (10a, 11, 27, 37).

3. Measuring device according to claim 2 having a gradiometer of 1st or higher order, characterized by a supporting structure (11) having a single supporting part for the gradiometer coils (14, 16), the connecting elements (17) and the small supporting plate (chip 19) of the direct current quantum interference elements.

4. Measuring device according to one of claims 1 to 3, characterized in that all gradiometer coils (14, 16) are arranged next to one another on a common flat side of the supporting structure (11) (Figure 2).

5. Measuring device according to claim 1 or 2, characterized in that the supporting structure (37) is composed of several parts (38, 39) (Figure 5).

6. Measuring device according to claim 5 having a gradiometer of 2nd order, characterized by a supporting structure with two supporting parts which are each provided with a gradiometer of 1st order.

7. Measuring device according to one of claims 1 to 6, characterized by a supporting structure (10a, 11, 27, 37) of quartz or silicon parts.

8. Measuring device according to one of claims 1 to 7, characterized in that the gradiometer coils (2 ; 14, 16 ; 40, 41) are arranged as a series (13) of detection coils (14 ; 40) and as a series (15) of compensation coils (16 ; 41) on the common supporting structure (10a, 11, 37).

9. Measuring device according to claim 8, characterized in that the detection coils (14, 40) have a different number of turns and/or different areas compared with the compensation coils (16, 41) associated with them.

10. Measuring device according to claim 8 or 9, characterized in that the detection coils (40) and the compensation coils (41) are arranged on different parallel flat sides (43, 44) of the supporting structure (37) (Figure 5).

11. Measuring device according to claim 10, characterized in that the direct current quantum interference elements (SQUID-chip 42) are arranged on a flat side (51) of the supporting structure (37) which lies in a different plane to the flat sides (43, 44) of the gradiometer coils (40, 41).

12. Measuring device according to claim 10 or 11, characterized in that the connections between the gradiometer coils (40, 41) located on the parallel flat sides (43, 44) are constructed as thin-film conductors (50) extending between the edges (47, 48) of these flat sides (43, 44).

13. Measuring device according to one of claims 10 to 12, characterized in that the connections between the gradiometer foils (40) and the direct current quantum interference elements (SQUID-chip 42) are constructed as thin-film conductors (53, 54) extending between the edges (47, 48, 56) of the flat sides (43, 51) supporting these parts.

14. Measuring device according to claim 12 or 13, characterized in that the connections of the superconducting conductor parts (45, 46, 50, 52 to 54) on the edges (47, 48, 56, 61) are constructed by solderings (59, 60, 64) with superconducting material in grooves (58, 62, 63).

15. Measuring device according to claim 14, characterized in that the edges (47, 48, 56, 61) provided with the grooves (58, 62, 63) are bevelled.

16. Measuring device according to one of claims 1 to 15, characterized in that the dimensions (diameter D) of the individual gradiometer coils (2 ; 14, 16 ; 40, 41) are adapted to the nearest magnetic field source to be detected, and in that means are provided for the composition of the signals of individual gradiometer coils into a common signal of a group of gradiometer coils in dependence upon the distance of the magnetic field source to be detected in each case.

17. Measuring device according to claim 16, characterized in that for the composition of the signals of individual gradiometer coils (2 ; 14, 16 ; 40, 41) the corresponding channels in the electronic device (8a) for the evaluation and processing of the information obtained by the quantum interference elements are connected together.

18. Measuring device according to claim 2, characterized in that the small supporting plate (26) is fastened on the supporting structure (27) indirectly by means of an intermediate support (chip-support 25) (Figure 4).

19. Measuring device according to claim 18, characterized in that the intermediate support (chip-support 25) is provided with slots (30) in the region of the superconducting conductor connections.

20. Method for the production of a measuring device according to one of claims 2, 18, 19, characterized in that first of all on the supporting structure (10a, 11, 27, 37) the gradiometer coils (2 ; 14, 16, 40, 41) are applied in planar lithography technology together with the connection conductors (5, 17, 29, 45, 46, 50, 52 to 54) extending between them and to the direct current quantum interference elements (4) located on the small supporting plate (chip 10b, 19, 25 and 26, 42), and in that independently thereof the direct current quantum interference elements (4) are constructed on the small supporting plate according to technology for the production of integrated circuits (IC technology), and in that subsequently the small supporting plate provided with the direct current quan-

tum interference elements is applied on to the supporting structure and is attached.

**Revendications**

1. Dispositif pour la mesure à canaux multiples de champs magnétiques faibles et variables dans une plage d'intensité de champ inférieure à $10^{-10}$ T, qui contient, dans chaque canal,
   – un élément d'interférence quantique supraconducteur (SQUID) (4),
   – un gradiamètre formé par des bobines supraconductrices (2), ainsi que
   – des éléments de liaison supraconducteurs (5) entre l'élément d'interférence quantique (4) et le gradiomètre, avec un transformateur de couplage et des conducteurs de connexion, et qui comprend, en outre, des dispositifs électroniques (6, 7, 8a, 8b) pour l'exploitation, le traitement et la représentation des informations obtenues sur les éléments d'interférence quantique (4), caractérisé en ce qu'il est prévu une structure de support rigide (10a, 11, 27, 37), sur laquelle sont prévus, en commun
   a) les éléments supraconducteurs d'interférence quantique à courant continu (DC-SQUIDs 4) qui forment une rangée (Array), et
   b) respectivement réalisées en tant que structures à couche mince dans un au dans plusieurs plans
   – les bobines du gradiomètre (2 ; 14, 16 ; 40, 41) qui sont associées aux éléments d'interférence quantique à courant continu, qui sont de réalisation planaire et qui forment au mains une rangée (Array), ainsi que
   – les éléments de liaison supraconducteurs (5), les bobines de gradiomètre et les éléments de connexion (17, 29, 45, 46, 50, 52, 53) étant disposés sur la structure de support.

2. Dispositif selon la revendication 1, caractérisé en ce que les éléments d'interférence quantique à courant continu (4) sont disposés sur une plaquette de support commune (puce 10b, 19, 26, 42) et cette plaquette de support est fixée rigidement sur la structure de support (10a, 11, 27, 37).

3. Dispositif selon la revendication 2, avec un gradiomètre d'ordre 1 ou d'ordre supérieur, caractérisé par une structure de support (11) avec une pièce de support unique pour les bobines de gradiomètre (14, 16), les éléments de liaison (17) et la plaquette de support (puce 19) des éléments d'interférence quantique à courant continu.

4. Dispositif selon une des revendications 1 à 3, caractérisé en ce que toutes les bobines de gradiomètre (14, 16) sont disposées les unes à côté des autres sur une face plane commune de la structure de support (11) (figure 2).

5. Dipositif selon la revendication 1 ou 2, caractérisé en ce que la structure de support (37) est composée de plusieurs parties (38, 39) (figure 5).

6. Dispositif selon la revendication 5, avec un gradiomètre d'ordre 2, caractérisé par une structure de support avec deux pièces de support, munies chacune d'un gradiomètre d'ordre 1.

7. Dispositif selon une des revendications 1 à 6, caractérisé par une structure de support (10a, 11, 27, 37) formée de pièces en quartz ou silicium.

8. Dispositif selon une des revendications 1 à 7, caractérisé en ce que les bobines de gradiomètre (2 ; 14, 16 ; 40, 41) sont disposées sur la structure de support commune (10a, 11, 37) comme une série (13) de bobines de détection (14 ; 40) et comme une série (15) de bobines de compensation (16 ; 41).

9. Dispositif selon la revendication 8, caractérisé en ce que les bobines de détection (14, 40) possèdent un nombre de spires et/ou des aires de surface qui diffèrent de ceux des bobines de compensation (16, 41) coordonnées à elles.

10. Dispositif selon la revendication 8 ou 9, caractérisé en ce que les bobines de détection (40) et les bobines de compensation (41) sont disposées sur les différentes faces planes parallèles (43, 44) de la structure de support (37) (figure 5).

11. Dispositif selon la revendication 10, caractérisé en ce que les éléments d'interférence quantique à courant continu (puce à SQUID 42) sont disposés sur une face (51) de la structure de support (37) qui est située dans un autre plan que les faces (43, 44) sur lesquelles se trouvent les bobines de gradiomètre (40, 41).

12. Dispositif selon la revendication 10 ou 11, caractérisé en ce que les connexions entre les bobines de gradiomètre (40, 41) se trouvant sur les faces parallèles (43, 44), sont réalisées sous forme de conducteurs à couche mince (50) s'étendant entre les arêtes (47, 48) de ces faces (43, 44).

13. Dispositif selon une des revendications 10 à 12, caractérisé en ce que les connexions entre les bobines de gradiomètre (40) et les éléments d'interférence quantique à courant continu (puce à SQUID 42) sont réalisées sous forme de conducteurs à couche mince (53, 54) s'étendant entre les arêtes (47, 48, 56) des faces (43, 51) portant ces composants.

14. Dispositif selon la revendication 12 ou 13, caractérisé en ce que la liaison des parties de conducteurs supraconductrices (45, 46, 50, 52 à 54) sur les arêtes (47, 48, 56, 61) sont réalisées par des soudures (59, 60, 64) avec du matériau supraconducteur dans des encoches (58, 62, 63).

15. Dispositif selon la revendication 14, caractérisé en ce que les arêtes (47, 48, 56, 61) pourvues des encoches (58, 62, 63) sont biseautées.

16. Dispositif selon une des revendications 1 à 15, caractérisé en ce que les dimensions (diamètre D) des différentes bobines de gradiomètre (2 ; 14, 16 ;

40, 41) sont adaptées à la source de champ magnétique à détecter située le plus proche du champ et que des moyens sont prévus pour réunir les signaux de différentes bobines de gradiomètre en un signal commun d'un groupe de bobines de gradiomètre en fonction de l'éloignement de la source de champ magnétique à détecter.

17. Dispositif selon la revendication 16, caractérisé en ce que, pour la réunion des signaux de différentes bobines de gradiomètre (2 ; 14, 16 ; 40, 41), les canaux correspondants sont connectés ensemble dans le dispositif électronique (8a) pour l'exploitation et le traitement des informations prélevées sur les éléments d'interférence quantique.

18. Dispositif selon la revendication 2, caractérisé en ce que la plaquette de support (26) est fixée sur la structure de support (27) au moyen d'un support intermédiaire (support de puce 25) (figure 4).

19. Dispositif selon la revendication 18, caractérisé en ce que le support intermédiaire (support de puce 25) est pourvu de fentes (30) dans la région des bornes supraconductrices des conducteurs.

20. Procédé pour fabriquer un dispositif de mesure selon une des revendications 2, 18, 19, caractérisé en ce que l'on applique d'abord, sur la structure de support (10a, 11, 27, 37), selon une technique de lithographie planaire, les bobines de gradiomètre (2 ; 14, 16, 40, 41), ensemble avec les conducteurs de connexion (5, 17, 29, 45, 46, 50, 52 à 54), s'étendant entre celles et vers les éléments d'interférence quantique à courant continu (4), se trouvant sur la plaquette de support (puce 10b, 19, 25 et 26, 42), qu'indépendamment de cela, on forme, sur la plaquette de support, selon une technique pour la fabrication de circuits intégrés (technique IC), les éléments d'interférence quantique à courant continu (4) et qu'ensuite, on applique sur la structure de support et on connecte la plaquette de support, munie des éléments d'interférence quantique à courant continu.

8b

8a

7

9 9 7

6 > 6 > 6

9

3 3

4 4 10b

10a

5 5

2 2 2

**FIG 1**

l

14 16

+ 17 18 23

17 21

b 13 20 22

19

15

14 16

D

12

**FIG 2**

FIG 3

FIG 4

FIG 5

FIG 6

FIG 7